# EUROPEAN PATENT APPLICATION

(11) **EP 2 299 591 A1**
(43) Date of publication of application: **23.03.2011**
(21) Application number: 09749966.9
(22) Date of filing: 20.05.2009
(51) Int. Cl.: H03G 3/32, H04R 29/00

(54) **AMBIENT SOUND CAPTURE AND MANAGEMENT DEVICE**

(30) Priority: 23.05.2008 ES 200801539
(71) Applicant: Crambo, S.a., Madrid (ES); Garcia Manchado, Nilo, 28850 Torrejon De Ardoz (ES)
(72) Inventor: GARCIA MANCHADO, Nilo, E-28850 Torrejón de Ardoz (Madrid) (ES)
(74) Representative: Temino Ceniceros, Ignacio
(86) International application number: PCT/ES2009/070170
(87) International publication number: WO 2009/141482

(57) **Abstract**

Device for capturing and managing background sounds, suitable to be used in earphones for listening to music or talking on the phone, as well as for use in operating vehicles with music turnedon , characterized because it includes at least:
a first means for capturing the background sound consisting in at least a microphone to capture the sounds that are external to the location where the element is installed; and
a second means for managing the sound captured by the first means, in such a way that the ambient sound is reproduced for the user after an analysis of the ambient sound peaks, which will be produced in several ways, as determined by the user.

## Description

The device for capturing and managing background sounds for use in earphones or moving vehicles with music turned on high, in such a way, that it can reproduce the ambient sounds mixed in with the music the user is listening to.

### INVENTION BACKGROUND

Most people, when listening to music are unaware of their surroundings because external sounds are not perceived by the user when for example, someone is inside a car and the music volume is set high or a user is listening to their player with earphones on, making it extremely difficult to hear what is occurring outside the vehicle.

We, the applicants, do not know of any device that includes the characteristics defined in this descriptive report.

### INVENTION DESCRIPTION

The device referred to in this invention consists in adding a microphone that receives external sounds and either mixes them with the music the user is listening to so that he can hear what is occurring outside while he is listening to music; or with the help of a sensitivity regulator of the external microphone, activates the speaker with ambient sounds when these sounds surpass the threshold defined by the user, in order to for example, hear the horn of a vehicle that is warning the pedestrian of a possible danger.

This microphone may be located in different areas; for example, along the length of the earphone cable or in the music player or telephone itself.

The microphone may also be located in the earphone themselves as long as they do not detect the audio that the user is listening to and includes everything required to carry out its function without considering the audio source; this way, someone with an MP3 player or mobile phone does not have to replace it because the earphones themselves carry out this function. The microphone of the mobile phone itself may be used to carry out this function and with the help of an external sounds management device in order to emit these sounds through the earphones.

This device can also notify the user with different alarms that have been prefixed for the purpose of, for example, telling him what time it is, the passing of time; for example one whistle sound every minute, a longer whistle sound every 10 minutes (this can help runners monitor the time elapsed) or any other message that occurs while the user is listening through the earphones for example, the reception of an e-mail or SMS message.

In other words, the invention includes several features; the first is a safety feature that prevents the user from being unaware of his surroundings while listening to something through earphones, thus endangering himself and/or others. To accomplish this, one or several sound capturing devices or microphones are used that detect ambient sounds and reproduces these sounds through the user's earphones. At the same time, these sounds may be reproduced in the earpiece that is nearest to the source; this can be accomplish by a device with two or more microphones connected to their respective sides, so the right microphone will reproduce the sound in the right earpiece so when sound is received from the right side, it will be heard in the right earpiece, thus providing the user with the direction of the source of the sound.

Another characteristic is that the sound from the music source or telephone can be cancelled, thus offering the user the ambient sound when it reaches a receivable threshold that is programmed by the user; this way, the user listens to music in a normal fashion and only when the exterior sounds surpass a determined tone or frequency for example, the sound of a horn, the microphone emits this source to the earphone by either mixing it with what the user is listening to or by cancelling the source and emitting the sound from the external source.

Another advantage consists in emitting temporary type information for example, a sounding watch or chronometer through aural signals or aural alarms of different strengths or in voice form, an aural message or alarm device that while listening to a sound source, a different source is simultaneously transmitted for the purpose of informing the user of an incoming call, that if registered in the telephone contacts, the user may know who is calling while listening to music because a voice synthesizer would let the person who is listening with the headset know who is calling.

The device also has the capability of interrupting the audio signal with SMS written type messages that may be played back using voice and the possibility of these messages being read to the user or mixed in with the music or by momentarily interrupting the music playback.

An additional characteristic consists in the device comparing the ambient sounds to a data base and selecting for example, the name of the user in order to notify him that someone is calling his name or has mentioned his name in a conversation, and after having identified that sound, it plays it back according to the characteristics that have been predefined by the user. This way, after someone has said his name, the user can immediately listen to the phrase in which his name has been included.

The device also includes means for recording all the sound events occurred during a time period predefined by the user, prior to it being played back that enables to hear the sound events that occurred while the user was listening to other contents via the earphone when desired.

As well as for earphones, this device may be applied for any vehicle. In the case of a car, the microphone or microphones would be installed outside the car and the occupants would only receive the admitted sounds or those that surpass a certain decibel level, and would be heard inside the vehicle by means of an audio device; likewise, since the sound has been identified, a signal or for example a pictogram or image of the sound that has been identified may be played back. In this case, the safety device enables users to listen to loud music without compromising safety.

This device may also be used to record all the ambient sound information and offer the user such sound events afterwards in a way that these sound emissions can be recorded in a floating memory that automatically deletes these in time as programmed by the user. The purpose of this function is to be able to rewind the sounds that were emitted at the user's location so that he can hear these afterwards with greater precision. For example, the user has a conversation with the earphones on or not and after a few minutes he realizes he wants to listen to the conversation since before the conversation took place, he had not began the recording so he can review the sound or video that was emitted before, without having the intention of recording them.

This characteristic may serve as evidence of an occurrence, for example, the user is taking a walk and he is held up by a crook; however, the user can only offer himself as a witness but with the help of this device, since it constantly records a period of time for example, the last hour, you could save the sound or video recording of such event to be used as evidence. This information can also be sent to a server via a data network, so regardless of weather or not the device is taken away from the user, the information will be available at a remote location out of the crooks reach; this other information at another location can also be used as evidence that such information was recorded at a date and time and by for example, adding a GPS signal, at a specific location. This file can also be linked to a systematic event for example, a bar code, so all this information can always be linked to for example, a customer invoice.

Throughout the description and claims, the word "encompasses" and its synonyms do not intend to exclude other technical characteristics, additions, components or steps. For experts in the field, other objectives, advantages and characteristics of this invention will in part be derived from the description and in part from placing the invention into practice. The following examples provide an illustration and are not intended to limit this invention. Additionally, this invention covers all the possible combinations of particular and preferred performances indicated herein.

### PREFERRED EMBODIMENT OF THE INVENTION

In a preferred embodiment of this invention, the background sounds capturing and managing device, suitable to be used in earphones for listening to music or talking on the phone, as well as for use in operating vehicles with music turned on, includes at least:
a first means for capturing the background sound consisting in at least a microphone to capture the sounds that are external to the location where the element is installed; and
a second means for managing the sound captured by the first means, in such a way that the ambient sound is reproduced for the user after an analysis of the ambient sound peaks, which will be reproduced in a manner selected between:
   a first reproduction method consisting in a mixing of ambient sound with the sound listened to by the user, in a way that for example, at home, a user can hear what is occurring around him without interrupting at any time what he is listening to and/or touching and therefore, not distracting him; or
   a second reproduction method consisting in the use of a third means for regulating the sensitivity of the capturing means, in a way that the second means activate a speaker emitting the ambient sound when said sound surpasses the threshold set by the user, where the primary sound the user is listening to is not interrupted but lowered, while the frequency range of the ambient sound is increased.

These second means for managing the captured sounds, for the digital analysis of the sound includes means configured for applying the Fast Fourier Transform (FFT). By applying said transform, we are able to identify the frequencies that comprise a sound wave.

Frequency is a unit of measurement that indicates the number of oscillations suffered by a wave per unit time. The human ear can perceive from 20Hz up to 20,000Hz. In order to detect horns and similar sounds, a study of ambient sounds has been carried out, which determined that the most relevant frequency range is from 1500Hz to 3000Hz. Below 1500Hz, we find all types of sounds and noise of great value in all environments, which correspond to the mixing of many sound sources. Above 3000Hz, we have extremely high pitched sounds that are not characteristic of the normal horn sounds.

By knowing the amplitude of the wave for a specific frequency, we may know how important this sound is for the whole sound. This way, controlling the changes in amplitude values, we can detect abnormal increases.

300 different values of the chosen frequency range are analyzed at each instant. Likewise, this second means include means for properly detecting the sound peaks by means of several simultaneous analyses.
(i) a first calculation of the average amplitude of all the frequencies of a moment in time: the average value present at each instant is calculated and if any of these frequencies surpasses by 3 times the average value, it is considered a possible peak.
(ii) a second analysis of deleting the sound considered noise: to prevent the previously calculated averages from being too low due to the fact that there are certain frequencies that barely appear, these frequencies are deleted and are not considered when calculating the average. The margin for considering a value as noise is 60% of the average value of the previous instant. This way, we are able to obtain a more reliable value for the measurement while taking into consideration the context of the sound.
(iii) a third filtering of peaks at low volume: In cases where the amount of sound is reduced; in other words, the volume or amplitude is reduced, peaks can easily appear caused by any sound. To prevent this, a global measuring of the sound is carried out in order to maintain information regarding the "volume" levels we are encountering. If at any moment, a frequency surpasses by 4 times this average volume, it is considered as a possible peak.

In order for a peak to be recognized as such, it must surpass the three aforementioned analyses and is then played back in the indicated way.

The ambient sound may be played back according to its special situation, sounding only on the side where the ambient sound originated. To accomplish this, the Doppler effect may be used so that only the sounds that are approaching will be reproduced and not those that are getting farther away.

The device plays back time type indicative sounds, by means of sound signals of different strengths in such a way that the user is simultaneously informed of alarms.

As an option, the device includes a voice synthesizer means so that a plurality of voice messages can be played back as well as a database so that ambient sounds are compared with a database, and the sound is identified.

The device described in this invention includes at least a recording means so that the sound events that occurred during a user predefined time period are recorded, that is, prior to the time in which it is played back; and where also, these recording means enable to record all the information of the ambient sound so that the sound events may be saved in a floating memory that is automatically deleted in a programmed way after a time period defined by the user.

## Claims

1. Device for capturing and managing background sounds, suitable to be used in earphones for listening to music or talking on the phone, as well as for use in operating vehicles with music turned on, **characterized** because it includes at least:
a first means for capturing the background sound consisting in at least a microphone to capture the sounds that are external to the location where the element is installed; and
a second means for managing the sound captured by the first means, in such a way that the ambient sound is played back for the user after an analysis of the ambient sound, and these sounds will be played back in a manner selected between:
a first reproduction means consisting in a simple mixing of the ambient sound with the sound the user is listening to; or
a second reroduction method consisting in the use of a third means for regulating the sensitivity of the capturing means, in a way that the second means activate a speaker emitting the ambient sound when said sound surpasses the threshold set by the user, after an analysis of the peaks of said ambient sound has been performed.

2. Device in accordance with claim 1 **characterized** because the ambient sound may be reproduced according to its special situation, sounding only on the side where the ambient sound originated.

3. Device in accordance with claims 1 and 2 **characterized** because it reproduces time type indicative sounds, by means of sound signals of different strengths in such a way that the user is simultaneously informed of alarms.

4. Device in accordance with claims 1 to 3 **characterized** because it includes a voice synthesizer means so that a plurality of voice messages can be reproduced.

5. Device in accordance with claims 1 to 4 **characterized** because it includes a database so that ambient sounds are compared with the database, and the sound is identified.

6. Device in accordance with prior claims **characterized** because it includes recording means so that the sound events that occurred during a user predefined time period that is prior to the time in which it is reproduced; and where also these recording means enable to record all the information of the ambient sound so that the sound events may be saved in a floating memory that is automatically deleted in a programmed way after a time period defined by the user.

7. Telephone **characterized** because it includes a device in accordance with claims 1 to 6.

8. An audio reproduction system **characterized** because it includes a device in accordance with claims 1 to 6.
